# EUROPEAN PATENT SPECIFICATION

(11) **EP 3 896 522 B1**
(45) Date of publication and mention of the grant of the patent: **03.05.2023**
(21) Application number: 19898305.8
(22) Date of filing: 26.11.2019
(51) Int. Cl.: G03F 7/42, G03F 7/075, G03F 7/023, H01L 21/033, H01L 21/266, H01L 21/311, C08G 77/16, C08G 77/00, C09D 183/04

(54) **PRODUCTION METHOD FOR SEMICONDUCTOR SUBSTRATE**
VERFAHREN ZUR HERSTELLUNG EINES HALBLEITERSUBSTRATS
PROCÉDÉ DE PRODUCTION DE SUBSTRAT SEMI-CONDUCTEUR

(30) Priority: 21.12.2018 JP 2018239593
(43) Date of publication of application: 20.10.2021
(73) Proprietor: TOKYO OHKA KOGYO CO., LTD., Kawasaki-shi, Kanagawa 211 0012 (JP)
(72) Inventor: MASUJIMA Masahiro, Kawasaki-shi, Kanagawa 211-0012 (JP); HIRANO lsao, Kawasaki-shi, Kanagawa 211-0012 (JP)
(74) Representative: Plasseraud IP
(86) International application number: PCT/JP2019/046154
(87) International publication number: WO 2020/129552

(56) References cited:
- EP-A1- 3 125 274
- EP-A1- 3 203 320
- EP-A2- 0 827 188
- WO-A1-2015/146749
- JP-A- H1 055 993
- JP-A- H08 250 400
- JP-A- H08 250 400
- JP-A- 2001 176 855
- JP-A- 2003 241 400
- JP-A- 2009 289 774

## Description

### TECHNICAL FIELD

The present invention relates to a method for producing a semiconductor substrate.

### BACKGROUND ART

In the manufacture of a semiconductor device, in order to form an impurity region in a semiconductor substrate to be processed, such as a silicon substrate, ions are implanted using a mask having an opening corresponding to the shape of the impurity region. Such a mask is typically formed by photolithography using a photoresist composition. Then, the mask used is removed after the formation of the impurity region. It is desirable that the mask be removed without residue, but residues may remain. For example, when the impurity region is formed by an ion implantation method, it is difficult to remove the mask after formation of the impurity region due to denaturation of the mask by ion implantation. While a mask formed using a composition containing an organopolysiloxane is advantageous in excellent heat resistance and the like, upon forming the impurity region by the ion implantation method, etc., it is difficult to remove the mask and a residue easily remains. As a technique for addressing the problem that such a residue tends to remain, Patent Document 1 discloses a technique relating to a method of producing a semiconductor device, the method including a step of obtaining a pattern of a composition containing a polysiloxane on a substrate, a step of forming an ion impurity region on the substrate, and further a step of burning the pattern at 300 to 1500°C after the step of forming the ion impurity region.

Patent Document 1: Pamphlet of PCT International Publication No. WO2015/146749

EP 3 125 274 A1, EP 3 203 320 A1 and JP H08 250400 A are documents that illustrate further relevant concepts known in the field.

### DISCLOSURE OF THE INVENTION

### Problems to be Solved by the Invention

However, when heating the semiconductor substrate at a high temperature after forming the impurity region as in Patent Document 1, there is concern that implanted dopants may diffuse, depending on the heating conditions, into a region which is undesirable for the dopants (impurities) to diffuse into, such as a region coated with a mask in the semiconductor substrate. When constructing a process, there is also a problem that it is necessary to introduce equipment to handle this heating.

In view of the above problems, an object of the present invention is to provide a method for producing a semiconductor substrate, in which after introducing dopants by an ion implantation method to a semiconductor substrate that is to be processed and that is provided with a mask formed using a composition containing an organopolysiloxane, the mask can be easily removed, while reducing residue.

### Means for Solving the Problems

As a result of extensive research to achieve the above object, the present inventors have found that the above problems can be solved by performing at least one of bringing a mask into contact with a first treatment liquid containing an oxidizing agent and irradiating the mask with plasma generated using an oxygen-containing gas and then bringing the mask into contact with a second treatment liquid containing fluoride ions, thereby completing the present invention.

The present invention relates to a method for producing a semiconductor substrate as defined in the appended set of claims.

### Effects of the Invention

According to the present invention, it is possible to provide a method of producing a semiconductor substrate, in which after introducing dopants by an ion implantation method to a semiconductor substrate that is to be processed and that is provided with a mask formed using a composition containing an organopolysiloxane consisting of a constituent unit represented by formula (1) and a constituent unit represented by formula (2), the mask can be easily removed, while reducing residue.

### PREFERRED MODE FOR CARRYING OUT THE INVENTION

The method for producing a semiconductor substrate of the present invention includes a mask formation step of forming a mask using an energy-sensitive composition containing an organopolysiloxane consisting of a constituent unit represented by formula (1) and a constituent unit represented by formula (2), an ion implantation step of implanting ions into the semiconductor substrate to be processed, which is provided with the mask, and a mask removal step of removing the mask. The mask removal step consists of a first step including at least one of contacting the mask with a first treatment liquid containing an oxidizing agent and irradiating the mask with plasma generated using an oxygen-containing gas, and a second step including bringing the mask after being subjected to the first step into contact with a second treatment liquid containing fluoride ions, wherein a temperature of the semiconductor substrate in the mask removal step is 200°C or less. Below, the respective steps are described in detail.

### <Mask formation step>

In the mask formation step, a mask is formed on a semiconductor substrate to be processed, using an energy-sensitive composition including an organopolysiloxane consisting of a constituent unit represented by formula (1) and a constituent unit represented by formula (2).

### (Semiconductor substrate to be processed)

As the semiconductor substrate to be processed, various substrates that have been conventionally used to form a semiconductor substrate may be used. As the semiconductor substrate to be processed, a silicon substrate is typically used. Since a semiconductor substrate to be processed, such as a silicon substrate, often includes a natural oxide film such as SiO₂ formed by spontaneous oxidation of the surface, a semiconductor substrate to be processed from which a natural oxide film on the surface is removed using an aqueous solution of hydrofluoric acid or the like may be used. Examples of other semiconductor substrates to be processed include substrates containing: silicon dioxide, silicon nitride, silicon carbide, gallium nitride, gallium phosphide, gallium arsenide, gallium aluminum arsenide, gallium indium nitrogen arsenide, indium nitride, indium phosphide, indium tin oxide (ITO), indium zinc oxide, indium gallium arsenide, indium gallium aluminum phosphorus, indium gallium zinc oxide, diamond, sapphire, aluminum zinc oxide, aluminum nitride, zinc oxide, zinc selenide, cadmium sulfide, and cadmium telluride. Further, the semiconductor substrate to be processed may be a substrate on which ITO, metal or carbon nanotubes are formed as an electrode or wiring on glass, for example.

(Energy-sensitive composition including an organopolysiloxane consisting of a constituent unit represented by formula (1) and a constituent unit represented by formula (2))

The energy-sensitive composition used in the mask formation step includes an organopolysiloxane. An organopolysiloxane refers to a polysiloxane consisting of a constituent unit represented by formula (1) and a constituent unit represented by formula (2).

By using an energy-sensitive composition containing an organopolysiloxane, a mask excellent in heat resistance and the like can be formed. Upon using a mask having excellent heat resistance, the mask is less likely to deform even when ion implantation or the like is performed at a high temperature, so that an impurity region can be formed in a desired region.

It is preferable that the energy-sensitive composition contains a photosensitizing agent. One of the two constituent units of the organopolysiloxane is represented by the following formula (1): 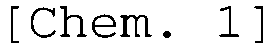 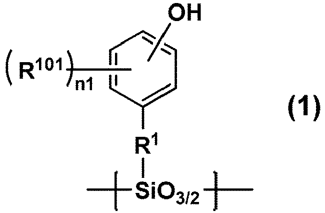 in which R¹ represents a single bond or an alkylene group, R¹⁰¹ represents an alkyl group, and n1 represents an integer of 0 or more and 4 or less.

In formula (1), when R¹ is a single bond, the benzene ring is directly bonded to the silicon atom. The alkylene group of R¹ preferably has 1 or more and 5 or less carbon atoms. The alkylene group of R¹ may be any of linear, branched, and cyclic alkylene groups. Examples of linear alkylene groups include a methylene group, an ethylene group, a propane-1,3-diyl group, a butane-1,4-diyl group, a pentane-1,5-diyl group, and the like. Examples of branched alkylene groups include a methylethylene group, a 1-methylpropane-1,3-diyl group, a 2-methylpropane-1,3-diyl group, a 1,1-dimethylethylene group, a 1-methylbutane-1,4-diyl group, a 2-methylbutane-1,4-diyl group, a 1,2-dimethylpropane-1,3-diyl group, a 1,1-dimethylpropane-1,3-diyl group, a 2,2-dimethylpropane-1,3-diyl group, and the like. As R¹, a linear alkylene group is preferred, and a methylene group or an ethylene group is particularly preferred.

In formula (1), the bonding position of the hydroxy group in the benzene ring is not particularly limited, but is preferably a para position with respect to the bonding position of R¹.

The benzene ring in formula (1) may have R¹⁰¹ as a substituent. The recitation "having R¹⁰¹" means that at least one or all of the hydrogen atoms bonded to the carbon atoms constituting the benzene ring are replaced by R¹⁰¹. As the alkyl group of R¹⁰¹, an alkyl group having 1 or more and 5 or less carbon atoms is preferred, and examples thereof include a methyl group, an ethyl group, a propyl group, an isopropyl group, an n-butyl group, an isobutyl group, a tert-butyl group, a pentyl group, an isopentyl group, a neopentyl group, etc. Industrially, a methyl group or an ethyl group is preferred. n1 is an integer of 0 or more and 4 or less, preferably 0 or 1, and particularly preferably 0.

The organopolysiloxane may contain only one type of the constituent unit represented by formula (1), or may contain two or more types thereof. The constituent unit represented by formula (1) contained in the organopolysiloxane is preferably contained in a content of 10 mol% or more, more preferably 25 mol% or more, and most preferably 30 mol% or more, with respect to the organopolysiloxane. When the content is 20 mol% or more, alkali solubility after exposure is improved, and a good pattern can be formed. The upper limit is not particularly limited, but is preferably 80 mol% or less, and most preferably 75 mol% or less.

The second constituent unit of the organopolysiloxane is represented by the following formula (2), an alkali dissolution inhibiting effect is improved by this unit. Therefore, the addition amount of the photosensitizing agent can be reduced. 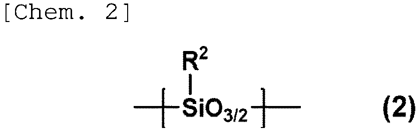 In which R² represents an aromatic hydrocarbon group or an alkyl group.

Examples of the aromatic hydrocarbon group of R² include a group obtained by removing one hydrogen atom from an aromatic ring which may or may not have a substituent. Examples of the aromatic ring include a benzene ring, a naphthalene ring, an anthracene ring, a phenanthrene ring, etc. Examples of the substituent that the aromatic ring may have include the same groups exemplified for the substituent R¹⁰¹ that the benzene ring in formula (1) may have. As the aromatic hydrocarbon group of R², particularly, a phenyl group or a phenanthryl group is preferred.

The alkyl group of R² may be any of linear, branched, and cyclic alkyl groups. The linear alkyl group preferably has 1 or more and 5 or less carbon atoms, and more preferably 1 or more and 3 or less carbon atoms. The branched alkyl group preferably has 3 or more and 5 or less carbon atoms, and may include, for example, 1-methylethyl group, 1-methylpropyl group, 2-methylpropyl group, 1,1-dimethylethyl group, 1-methylbutyl group, 2-methylbutyl group, 3-methylbutyl group, 1,2-dimethylpropyl group, 1,1-dimethylpropyl group, 2,2-dimethylpropyl group, etc. As the cyclic alkyl group, a group having a number of ring carbon atoms (number of carbon atoms constituting the ring) of 3 or more and 10 or less is preferred, and a cyclopentyl group or a cyclohexyl group is more preferred. The cyclic alkyl group may have a substituent bonded to the ring, and examples of the substituent include the same groups as substituents exemplified for R¹⁰¹ in formula (1). As the alkyl group of R², particularly, a linear alkyl group having 3 or more and 5 or less carbon atoms is preferred.

The organopolysiloxane may contain only one type of the constituent unit represented by formula (2), or may contain two or more types thereof. The constituent unit represented by formula (2) contained in the organopolysiloxane is preferably contained in a range of 5 mol% or more and 80 mol% or less, more preferably 10 mol% or more and 75 mol% or less, and most preferably 20 mol% or more and 70 mol% or less, with respect to the organopolysiloxane. When the content is equal to or higher than the lower limit value of the above range, an effect due to containing the constituent unit represented by formula (2) is sufficiently obtained, and when the content is equal to or lower than the upper limit value, balance with other constituent units is good.

A mass average molecular weight (Mw) (in terms of polystyrene by gel permeation chromatography (GPC), hereinafter, the same applies) of the organopolysiloxane is not particularly limited. The mass average molecular weight (Mw) is preferably 2,000 or more and 15,000 or less, and more preferably 2,500 or more and 10,000 or less. When the mass average molecular weight is within this range, solubility in an organic solvent is good. Further, Mw/number average molecular weight (Mn) is not particularly limited. The Mw/number average molecular weight (Mn) is preferably 1.0 or more and 6.0 or less, and more preferably 1.0 or more and 2.0 or less. When the Mw/number average molecular weight (Mn) is within this range, resolution and pattern shape are good. The organopolysiloxane can be produced, for example, by the method described in Japanese Patent No. 2567984.

The photosensitizing agent contained in the energy-sensitive composition is not particularly limited as long as it is a photosensitizing agent commonly used in positive resist compositions. As the photosensitizing agent, a compound having a naphthoquinonediazide group (a quinonediazide group-containing compound) is preferred. Examples of the quinonediazide group-containing compound include an esterified product of a naphthoquinonediazide sulfonic acid compound and a phenol compound.

Examples of the above-mentioned naphthoquinonediazide sulfonic acid compound include naphthoquinone-1,2-diazide-5-sulfonic acid or naphthoquinone-1,2-diazide-4-sulfonic acid and the like. Examples of the phenol compound include polyhydroxybenzophenone compounds, such as 2,3,4-trihydroxybenzophenone, 2,3,4,4'-tetrahydroxybenzophenone, etc.;
trisphenol type compounds, such as tris (4-hydroxyphenyl)methane, bis(4-hydroxy-3-methylphenyl)-2-hydroxyphenylmethane, bis(4-hydroxy-2,3,5-trimethylphenyl)-2-hydroxyphenylmethane, bis(4-hydroxy-3,5-dimethylphenyl)-4-hydroxyphenylmethane, bis(4-hydroxy-3,5-dimethylphenyl)-3-hydroxyphenylmethane, bis(4-hydroxy-3,5-dimethylphenyl)-2-hydroxyphenylmethane, bis(4-hydroxy-2,5-dimethylphenyl)-4-hydroxyphenylmethane, bis(4-hydroxy-2,5-dimethylphenyl)-3-hydroxyphenylmethane, bis(4-hydroxy-2,5-dimethylphenyl)-2-hydroxyphenylmethane, bis(4-hydroxy-3,5-dimethylphenyl)-3,4-dihydroxyphenylmethane, bis(4-hydroxy-2,5-dimethylphenyl)-3,4-dihydroxyphenylmethane, bis(4-hydroxy-2,5-dimethylphenyl)-2,4-dihydroxyphenylmethane, bis(4-hydroxyphenyl)-3-methoxy-4-hydroxyphenylmethane, bis(5-cyclohexyl-4-hydroxy-2-methylphenyl)-4-hydroxyphenylmethane, bis(5-cyclohexyl-4-hydroxy-2-methylphenyl)-3-hydroxyphenylmethane, bis(5-cyclohexyl-4-hydroxy-2-methylphenyl)-2-hydroxyphenyl methane, bis(5-cyclohexyl-4-hydroxy-2-methylphenyl)-3,4-dihydroxyphenyl methane, etc.;
linear polyphenol compounds, including linear trinuclear phenol compounds such as 2,4-bis(3,5-dimethyl-4-hydroxybenzyl)-5-hydroxyphenol, 2,6-bis(2,5-dimethyl-4-hydroxybenzyl)-4-methylphenol, etc.,
linear tetranuclear phenol compounds such as 1,1-bis[3-(2-hydroxy-5-methylbenzyl)-4-hydroxy-5-cyclohexylphenyl]isopropane, bis[2,5-dimethyl-3-(4-hydroxy-5-methylbenzyl)-4-hydroxyphenyl]methane, bis[2,5-dimethyl-3-(4-hydroxybenzyl)-4-hydroxyphenyl]methane, bis[3-(3,5-dimethyl-4-hydroxybenzyl)-4-hydroxy-5-methylphenyl]methane, bis[3-(3,5-dimethyl-4-hydroxybenzyl)-4-hydroxy-5-ethylphenyl]methane, bis[3-(3,5-diethyl-4-hydroxybenzyl)-4-hydroxy-5-methylphenyl]methane, bis[3-(3,5-diethyl-4-hydroxybenzyl)-4-hydroxy-5-ethylphenyl]methane, bis[2-hydroxy-3-(3,5-dimethyl-4-hydroxybenzyl)-5-methylphenyl]methane, bis[2-hydroxy-3-(2-hydroxy-5-methylbenzyl)-5-methylphenyl]methane, bis[4-hydroxy-3-(2-hydroxy-5-methylbenzyl)-5-methylphenyl]methane, bis[2,5-dimethyl-3-(2-hydroxy-5-methylbenzyl)-4-hydroxyphenyl]methane, etc., and
linear pentanuclear phenol compounds such as 2,4-bis[2-hydroxy-3-(4-hydroxybenzyl)-5-methylbenzyl]-6-cyclohexylphenol, 2,4-bis[4-hydroxy-3-(4-hydroxybenzyl)-5-methylbenzyl]-6-cyclohexylphenol, 2,6-bis[2,5-dimethyl-3-(2-hydroxy-5-methylbenzyl)-4-hydroxybenzyl]-4-methylphenol, etc.; bisphenol type compounds such as bis(2,3,-trihydroxyphenyl)methane, bis(2,4-dihydroxyphenyl) methane, 2,3,4-trihydroxyphenyl-4'-hydroxyphenylmethane, 2-(2,3,4-trihydroxyphenyl)-2-(2',3',4'-trihydroxyphenyl) propane, 2-(2,4-dihydroxyphenyl)-2-(2',4'-dihydroxyphenyl)propane, 2-(4-hydroxyphenyl)-2-(4'-hydroxyphenyl) propane, 2-(3-fluoro-4-hydroxyphenyl)-2-(3'-fluoro-4'-hydroxyphenyl)propane, 2-(2,4-dihydroxyphenyl)-2-(4'-hydroxyphenyl)propane, 2-(2,3,4-trihydroxyphenyl)-2-(4'-hydroxyphenyl)propane, 2-(2,3,4-trihydroxyphenyl)-2-(4'-hydroxy-3',5'-dimethylphenyl)propane, etc.;
polynuclear branched compounds such as 1-[1-(4-hydroxyphenyl)isopropyl]-4-[1,1-bis(4-hydroxyphenyl)ethyl]benzene, 1-[1-(3-methyl-4-hydroxyphenyl)isopropyl]-4-[1,1-bis(3-methyl-4-hydroxyphenyl)ethyl]benzene, etc.; and
condensed phenol compounds such as 1,1-bis (4-hydroxyphenyl)cyclohexane, etc.

The esterified product of a naphthoquinonediazide sulfonic acid compound and a phenol compound can be produced, for example, by condensing the afore-mentioned phenol compound with naphthoquinone-1,2-diazide-5-sulfonyl chloride or naphthoquinone-1,2-diazide-4-sulfonyl chloride in the presence of an alkali such as triethanol amine, alkali carbonate, alkali bicarbonate, or the like in a suitable solvent such as dioxane, to esterify at least one or all of the hydroxy groups. The above esterified product preferably has an esterification ratio of 40% or more and 100% or less, and more preferably 50% or more and 100% or less. The esterification ratio can be obtained by [(number of hydroxy groups esterified)/(total number of hydroxy groups (of phenol compound) before esterification)] × 100.

Further, other quinonediazide group-containing compounds than those described above can be used. Examples of the other quinonediazide group-containing compounds include orthoquinonediazides, such as orthobenzoquinonediazide, orthonaphthoquinonediazide, orthoanthraquinonediazide, etc.; nuclear substituted derivatives thereof (e.g., orthonaphthoquinonediazide sulfonate esters, etc.); reaction products of orthoquinonediazide sulfonyl chloride and a compound having a hydroxy group or an amino group (e.g., phenol, p-methoxyphenol, dimethylphenol, hydroquinone, bisphenol A, naphthol, pyrocatechol, pyrogallol, pyrogallol monomethyl ether, pyrogallol-1,3-dimethyl ether, gallic acid, an ester or ether of gallic acid, obtained by esterifying or etherifying at least one hydroxy group of gallic acid, leaving at least one hydroxy group, aniline, p-aminodiphenylamine, etc.); and the like.

These may be used singly or two or more types may be combined and used. As the photosensitizing agent, particularly, the esterified product of a phenol compound represented by the following formula (6) and a naphthoquinonediazide sulfonic acid compound is preferred. 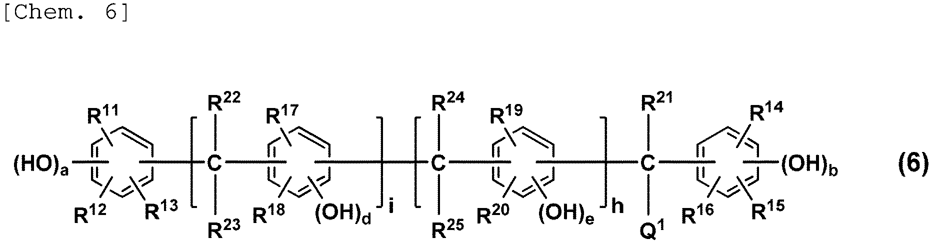 in which R¹¹ to R²⁰ each independently represents a hydrogen atom, a halogen atom, an alkyl group having 1 to 6 carbon atoms or an alkoxy group having 1 to 6 carbon atoms, R²² to R²⁵ each independently represents a hydrogen atom or an alkyl group having 1 to 6 carbon atoms, R²¹ represents a hydrogen atom or an alkyl group having 1 to 6 carbon atoms, Q¹ represents a hydrogen atom, an alkyl group having 1 to 6 carbon atoms, or a group represented by formula (7) below, or a R²¹ terminal and a Q1 terminal may be bonded to form an alkylene group having 2 to 5 carbon atoms, a and b each independently represents an integer of 1 to 3 carbon atoms, d and e each independently represents an integer of 0 to 3, and h and i represent integers satisfying that a value of h + i is 0 or more and 3 or less. 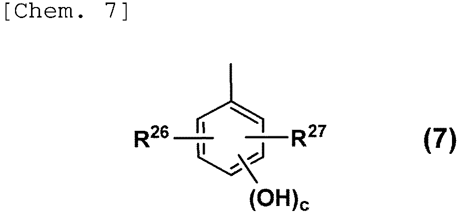 in which R²⁶ and R²⁷ each independently represents a hydrogen atom, a halogen atom, an alkyl group having 1 or more and 6 or less carbon atoms or an alkoxy group having 1 or more and 6 or less carbon atoms, and c represents an integer of 1 or more and 3 or less.

Examples of halogen atoms in R¹¹ to R²⁰, R²⁶, and R²⁷ include a fluorine atom, a chlorine atom, a bromine atom, an iodine atom, etc. The alkyl group in R¹¹ to R²⁷ may be any of linear, branched, and cyclic alkyl groups, and particularly, a methyl group or a cyclohexyl group is preferred. When the terminal of R²¹ and the terminal of Q¹ are bonded to form an alkylene group having 2 or more and 5 or less carbon atoms, a cyclic alkyl group having 3 or more and 6 or less carbon atoms is formed by Q¹, R²¹, and carbon atoms between Q¹ and R²¹.

The amount of the photosensitizing agent to be blended is preferably 5 parts by mass or more and 200 parts by mass or less, more preferably 5 parts by mass or more and 100 parts by mass or less, more preferably 5 parts by mass or more and 50 parts by mass or less, and most preferably 10 parts by mass or more and 35 parts by mass or less, with respect to 100 parts by weight of the organopolysiloxane. When the amount is equal to or higher than the lower limit value of the above range, sensitivity, resolution, and the like are improved, and when the amount is equal to or lower than the upper limit value, transparency, insulating property, low dielectric constant, and the like of the obtained film are improved.

The energy-sensitive composition used in the mask formation step may further contain an acid generator that generates an acid by irradiation (exposure) with radiation as an optional component within a range not impairing the effect of the present invention. By containing an acid generator, sensitivity, resolution, and the like are improved. The acid generator is not particularly limited. As the acid generator, acid generators which have been thus far proposed for a chemically amplified resist can be used. As such an acid generator, numerous acid generators are known, including onium salt-based acid generators such as iodonium salts and sulfonium salts; oxime sulfonate-based acid generators; diazomethane-based acid generators such as bisalkyl or bisaryl sulfonyl diazomethanes, poly(bis-sulfonyl)diazomethanes, etc.; nitrobenzylsulfonate-based acid generators; iminosulfonate-based acid generators; and disulfone-based acid generators, etc.

Examples of the onium salt-based acid generators include an acid generator represented by the following formula (a1): 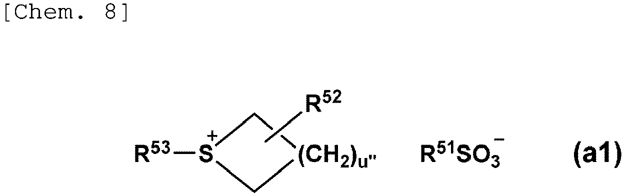 in which R⁵¹ represents a linear, branched, or cyclic alkyl group, or a linear, branched, or cyclic fluorinated alkyl group, and R⁵² represents a hydrogen atom, a hydroxy group, a halogen atom, a linear or branched alkyl group, a linear or branched halogenated alkyl group, or a linear or branched alkoxy group, R⁵³ represents an aryl group which may have a substituent, and u" represents an integer of 1 or more and 3 or less.

In formula (a1), R⁵¹ represents a linear, branched, or cyclic alkyl group, or a linear, branched, or cyclic fluorinated alkyl group. The linear or branched alkyl group preferably has 1 or more and 10 or less carbon atoms, more preferably 1 or more and 8 or less carbon atoms, and most preferably 1 or more and 4 or less carbon atoms. The cyclic alkyl group preferably has 4 or more and 12 or less carbon atoms, more preferably 5 or more and 10 or less carbon atoms, and most preferably 6 or more and 10 or less carbon atoms. The fluorinated alkyl group preferably has 1 or more and 10 or less carbon atoms, more preferably 1 or more and 8 or less carbon atoms, and most preferably 1 or more and 4 or less carbon atoms. In addition, the fluorination ratio of the fluorinated alkyl group (proportion of the number of fluorine atoms replaced with respect to the number of total hydrogen atoms in the alkyl group) is preferably 100 or more and 100% or less, and more preferably 50% or more and 100% or less. Particularly, a fluorinated alkyl group in which all of the hydrogen atoms are replaced by fluorine atoms is preferred in view of strong acid strength. As R⁵¹, a linear alkyl group or a fluorinated alkyl group is most preferred.

R⁵² is a hydrogen atom, a hydroxy group, a halogen atom, a linear or branched alkyl group, a linear or branched halogenated alkyl group, or a linear or branched alkoxy group. In R⁵², as the halogen atom, a fluorine atom, a bromine atom, a chlorine atom, an iodine atom, etc. can be mentioned and a fluorine atom is preferred. In R⁵², the alkyl group is linear or branched, and the number of carbon atoms thereof is preferably 1 or more and 5 or less, particularly 1 or more and 4 or less, and even 1 or more and 3 or less. In R⁵², the alkyl halide group is a group in which at least one or all of the hydrogen atoms in the alkyl group are replaced by halogen atoms. Examples of the alkyl group herein include the same groups as those exemplified for the "alkyl group" in R⁵². Examples of the substituting halogen atom include the same as those described above for the "halogen atom". In the halogenated alkyl group, it is preferable that 50% or more and 100% or less of the total number of hydrogen atoms is replaced by a halogen atom, and more preferably, all of them are substituted. In R⁵², the alkoxy group is linear or branched, and the number of carbon atoms thereof is preferably 1 or more and 5 or less, particularly 1 or more and 4 or less, and even 1 or more and 3 or less. As R⁵², a hydrogen atom is preferred among these.

R⁵³ is an aryl group that may have a substituent, and examples of the structure of a basic ring (base ring) excluding the substituent include a naphthyl group, a phenyl group, an anthryl group, and the like, and a phenyl group is desirable from a viewpoint of the effect of the present invention and absorption of exposure light such as ArF excimer laser. Examples of the substituent include a hydroxy group, a lower alkyl group (a linear or branched chain, and a preferable number of carbon atoms thereof is 5 or less, and a methyl group is particularly preferable), and the like. It is more preferred that the aryl group of R⁵³ has no substituent. u" is an integer of 1 or more and 3 or less, and is preferably 2 or 3, and particularly preferably 3.

Preferred specific examples of the acid generator represented by formula (a1) include the following compounds:

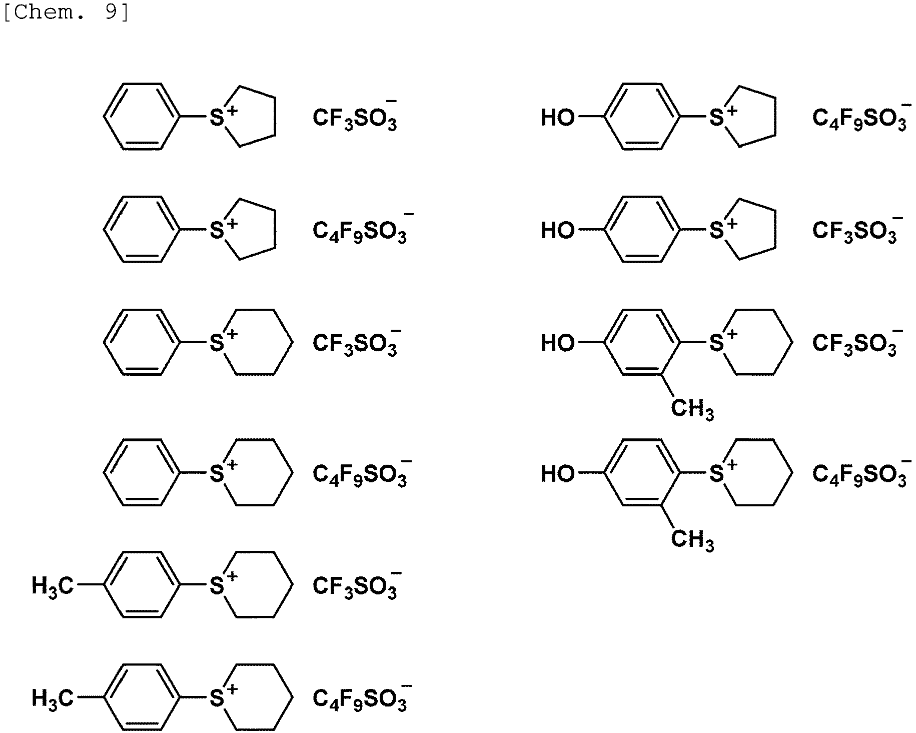

Further, examples of the other onium salt-based acid generator of the acid generator represented by formula (a1) include compounds represented by the following formula (a2) or (a3), for example: 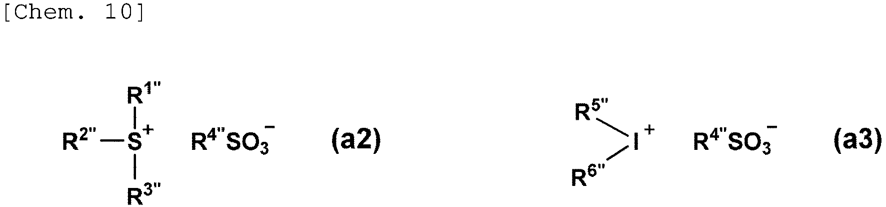 in which R¹" to R³" and R⁵" to R⁶" each independently represents an aryl group or an alkyl group; R⁴" represents a linear, branched, or cyclic alkyl group or a fluorinated alkyl group; at least one of R¹" to R³" represents an aryl group; and at least one of R⁵" to R⁶" represents an aryl group.

In formula (a2), R¹" to R³" each independently represents an aryl group or an alkyl group. At least one of R¹" to R³" represents an aryl group. Two or more of R¹" to R³" are preferably aryl groups, and most preferably, all of R¹" to R³" are aryl groups. The aryl group of R¹" to R³" is not particularly limited, and is, for example, an aryl group having 6 or more and 20 or less carbon atoms. At least one or all of the hydrogen atoms of the aryl group may or may not be replaced by an alkyl group, an alkoxy group, a halogen atom, or the like. As the aryl group, an aryl group having 6 or more and 10 or less carbon atoms is preferred because it can be synthesized at low cost. Specific examples thereof include a phenyl group and a naphthyl group. As the alkyl group by which the hydrogen atom of the aryl group may be replaced, an alkyl group having 1 to 5 carbon atoms is preferable, and a methyl group, an ethyl group, a propyl group, an n-butyl group, or a tert-butyl group is most preferable. As the alkoxy group by which the hydrogen atom of the aryl group may be replaced, an alkoxy group having 1 or more and 5 or less carbon atoms is preferred, and a methoxy group and an ethoxy group are most preferred. As the halogen atom by which the hydrogen atom of the aryl group may be replaced, a fluorine atom is preferred. There is no particular limitation on the alkyl group of R¹" to R³". Examples of preferred alkyl groups include linear, branched, or cyclic alkyl groups having 1 or more and 10 or less carbon atoms. From a viewpoint of excellent resolution, the number of carbon atoms of the alkyl group is more preferably 1 or more and 5 or less. Specific examples of suitable alkyl groups include a methyl group, an ethyl group, an n-propyl group, an isopropyl group, an n-butyl group, an isobutyl group, an n-pentyl group, a cyclopentyl group, a hexyl group, a cyclohexyl group, a nonyl group, a decanyl group, etc. Of the above alkyl groups, a methyl group is preferred because of excellent resolution and inexpensive synthesis of the acid generators. Of these, each of R¹" to R³" is most preferably a phenyl group or a naphthyl group.

R⁴" represents a linear, branched, or cyclic alkyl group or a fluorinated alkyl group. The linear or branched alkyl group preferably has 1 or more and 10 or less carbon atoms, more preferably 1 or more and 8 or less carbon atoms, and most preferably 1 or more and 4 or less carbon atoms. As the cyclic alkyl group, a cyclic group that is as shown in R¹" and that has 4 or more and 15 or less carbon atoms is preferred. The number of carbon atoms is more preferably 4 or more and 10 or less carbon atoms, and most preferably 6 or more and 10 or less carbon atoms. The fluorinated alkyl group preferably has 1 or more and 10 or less carbon atoms, more preferably 1 or more and 8 or less carbon atoms, and most preferably 1 or more and 4 or less carbon atoms. Further, the fluorination ratio of the fluorinated alkyl group (proportion of fluorine atoms in the alkyl group) is preferably 100 or more and 100% or less, more preferably 50% or more and 100% or less. Particularly, an alkyl group in which all of the hydrogen atoms are replaced by fluorine atoms is preferred in view of strong acid strength. As R⁴", a linear or cyclic alkyl group, or a fluorinated alkyl group is the most preferred.

In formula (a3), R⁵" to R⁶" each independently represents an aryl group or an alkyl group. At least one of R⁵" to R⁶" represents an aryl group. It is preferred that all of R⁵" to R⁶" are an aryl group. Examples of the aryl group of R⁵" to R⁶" include the same groups as those exemplified for R¹" to R³". Examples of the alkyl group of R⁵" to R⁶" include the same groups as those exemplified for R¹" to R³". Of these, it is most preferred that all of R⁵" to R⁶" are phenyl groups. Examples of R⁴" in formula (a3) include the same groups as those exemplified for R⁴" in formula (a2).

Specific examples of the onium salt-based acid generator represented by formula (a2) or (a3) include:
trifluoromethanesulfonate or nonafluorobutanesulfonate of diphenyliodonium; trifluoromethanesulfonate or nonafluorobutanesulfonate of bis(4-tert-butylphenyl)iodonium; trifluoromethanesulfonate, heptafluoropropanesulfonate, or nonafluorobutanesulfonate of triphenylsulfonium; trifluoromethanesulfonate, heptafluoropropanesulfonate, or nonafluorobutanesulfonate of tri(4-methylphenyl)sulfonium; trifluoromethanesulfonate, heptafluoropropanesulfonate, or nonafluorobutanesulfonate of dimethyl(4-hydroxynaphthyl)sulfonium; trifluoromethanesulfonate, heptafluoropropanesulfonate, nonafluorobutanesulfonate of monophenyldimethylsulfonium; trifluoromethanesulfonate, heptafluoropropanesulfonate, nonafluorobutanesulfonate of diphenylmonomethylsulfonium; trifluoromethanesulfonate, heptafluoropropanesulfonate, nonafluorobutanesulfonate of (4-methylphenyl)diphenylsulfonium; trifluoromethanesulfonate, heptafluoropropanesulfonate, nonafluorobutanesulfonate of (4-methoxypheny)diphenyl sulfonium; trifluoromethanesulfonate, heptafluoropropanesulfonate, nonafluorobutanesulfonate of tri(4-tert-butyl)phenylsulfonium; trifluoromethanesulfonate, heptafluoropropanesulfonate, nonafluorobutanesulfonate of diphenyl(1-(4-methoxy)naphthyl) sulfonium; trifluoromethanesulfonate, heptafluoropropanesulfonate, nonafluorobutanesulfonate of di(1-naphthyl)phenylsulfonium, etc. Further, it is possible to use onium salts, in which the anion moieties of these onium salts are replaced by methanesulfonate, n-propanesulfonate, n-butanesulfonate, or n-octanesulfonate.

In addition, onium salt-based acid generators in which the anion moiety in formula (a2) or (a3) is replaced by the anion moiety represented by the following formula (a4) or (a5) also can be used (the cation moiety is the same as in (a2) or (a3)). 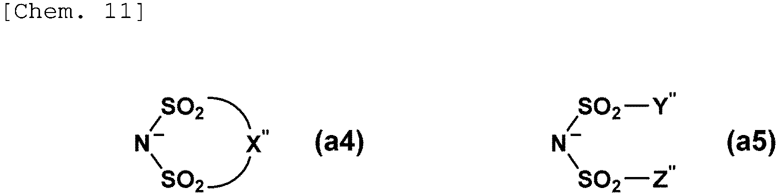 in which X" represents an alkylene group having 2 or more and 6 or less carbon atoms in which at least one hydrogen atom is replaced by a fluorine atom, and Y" and Z" each independently represents an alkyl group having 1 or more and 10 or less carbon atoms in which at least one hydrogen atom is replaced by a fluorine atom.

X" is a linear or branched alkylene group in which at least one hydrogen atom is replaced by a fluorine atom, and the number of carbon atoms of the alkylene group is 2 or more and 6 or less, preferably 3 or more and 5 or less, and most preferably 3 carbon atoms. Y" and Z" each independently represents a linear or branched alkyl group in which at least one hydrogen atom is replaced by a fluorine atom, and the number of carbon atoms of the alkyl group is 1 or more and 10 or less, preferably 1 or more and 7 or less, and more preferably 1 or more and 3 or less. The number of carbon atoms of the alkylene group of X" or the number of carbon atoms of the alkyl group of Y" and Z" is preferably as small as possible within the above range of the number of carbon atoms, for reasons such as good solubility in a solvent. In addition, in the alkylene group of X" or the alkyl group of Y" or Z", as the number of hydrogen atoms replaced by a fluorine atom is larger, acid strength is higher, and transparency to high energy light or electron beam of 200 nm or less is higher. The proportion of fluorine atoms in the alkylene group or the alkyl group, that is, the fluorination ratio, is preferably 70% or more and 100% or less, more preferably 90% or more and 100% or less, and a perfluoroalkylene group or a perfluoroalkyl group in which all hydrogen atoms are replaced by fluorine atoms is most preferred.

In this specification, the oxime sulfonate-based acid generator refers to a compound having at least one group represented by the following formula (a6), and has a property of generating an acid by irradiation with radiation. Since such an oxime sulfonate-based acid generator is widely used for a chemically amplified resist composition, an oxime sulfonate-based acid generator can be arbitrarily selected and used. 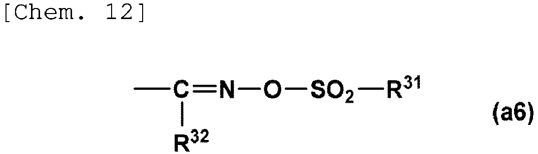 in which R³¹ and R³² each independently represents an organic group.

The organic group of R³¹ or R³² refers to a group containing a carbon atom, and may have an atom other than a carbon atom (e.g., hydrogen atom, oxygen atom, nitrogen atom, sulfur atom, halogen atom (fluorine atom, chlorine atom, etc.) . As the organic group of R³¹, a linear, branched, or cyclic alkyl group or an aryl group is preferred. These alkyl and aryl groups may have substituents. The substituent is not particularly limited, and examples thereof include a halogen atom such as a fluorine atom, a linear, branched, or cyclic alkyl group having 1 or more and 6 or less carbon atoms, etc. Here, "having a substituent" means that at least one or all of the hydrogen atoms of an alkyl group or an aryl group are replaced by substituents. The alkyl group preferably has 1 or more and 20 or less carbon atoms, more preferably 1 or more and 10 or less carbon atoms, more preferably 1 or more and 8 or less carbon atoms, more preferably 1 or more and 6 or less carbon atoms, and most preferably 1 or more and 4 or less carbon atoms. As the alkyl group, particularly, a partially or fully halogenated alkyl group (hereinafter, sometimes referred to as a halogenated alkyl group) is preferred. Note that a partially halogenated alkyl group refers to an alkyl group in which a part of the hydrogen atoms is replaced by a halogen atom, and a fully halogenated alkyl group refers to an alkyl group in which all of the hydrogen atoms are replaced by halogen atoms. Examples of the halogen atoms include a fluorine atom, a chlorine atom, a bromine atom, and an iodine atom, and a fluorine atom is particularly preferred. In other words, the halogenated alkyl group is preferably a fluorinated alkyl group. The aryl group preferably has 4 or more and 20 or less carbon atoms, more preferably 4 or more and 10 or less carbon atoms, and most preferably 6 or more and 10 or less carbon atoms. As the aryl group, a partially or fully halogenated aryl group is particularly preferred. Note that the partially halogenated aryl group refers to an aryl group in which a part of the hydrogen atoms is replaced by a halogen atom, and the fully halogenated aryl group refers to an aryl group in which all of the hydrogen atoms are replaced by halogen atoms. As R³¹, an alkyl group having 1 or more and 4 or less carbon atoms and having no substituent, or a fluorinated alkyl group having 1 or more and 4 or less carbon atoms is particularly preferred.

As the organic group of R³², a linear, branched, or cyclic alkyl group, an aryl group, or a cyano group is preferred. Examples of the alkyl group and the aryl group as R³² include the same groups as those exemplified for R³¹. As R³², a cyano group, an alkyl group having 1 or more and 8 or less carbon atoms and having no substituent, or a fluorinated alkyl group having 1 or more and 8 or less carbon atoms is particularly preferred.

Examples of further preferred oxime sulfonate-based acid generators include compounds represented by the following formula (a7) or (a8): 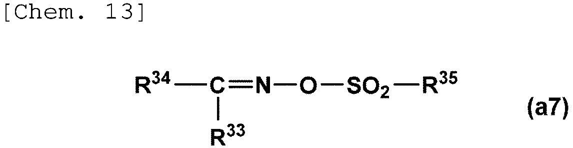
in which R³³ is a cyano group, an alkyl group having no substituent or a halogenated alkyl group,
R³⁴ is an aryl group, and
R³⁵ is an alkyl group having no substituent or a halogenated alkyl group.

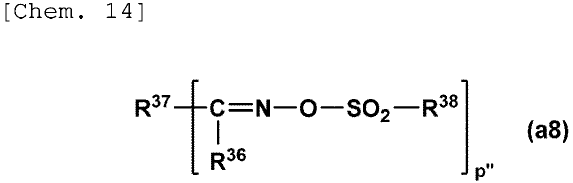

in which R³⁶ is a cyano group, an alkyl group having no substituent, or a halogenated alkyl group,
R³⁷ is a di- or tri-valent aromatic hydrocarbon group,
R³⁸ is an alkyl group having no substituent or a halogenated alkyl group, and
p" is 2 or 3.

In formula (a7), the alkyl group having no substituent or the halogenated alkyl group as R³³ preferably has 1 or more and 10 or less carbon atoms, more preferably 1 or more and 8 or less carbon atoms, and most preferably 1 or more and 6 or less carbon atoms. As R³³, a halogenated alkyl group is preferred, and a fluorinated alkyl group is more preferred. In the fluorinated alkyl group in R³³, 50% or more, preferably 70% or more, and most preferably 90% or more of hydrogen atoms is fluorinated.

Examples of the aryl group of R³⁴ include a group obtained by removing one hydrogen atom from a ring of an aromatic hydrocarbon, such as a phenyl group, a biphenyl group, a fluorenyl group, a naphthyl group, an anthryl group, and a phenanthryl group, as well as a heteroaryl group in which a part of the carbon atoms constituting a ring of these groups is replaced by a heteroatom such as an oxygen atom, a sulfur atom, a nitrogen atom, or the like. Among these, a fluorenyl group is preferred. The aryl group of R³⁴ may have a substituent such as an alkyl group having 1 or more and 10 or less carbon atoms, a halogenated alkyl group, an alkoxy group, or the like. The alkyl group or the halogenated alkyl group in the substituent preferably has 1 or more and 8 or less carbon atoms, and more preferably 1 or more and 4 or less carbon atoms. Further, it is preferable that the halogenated alkyl group is a fluorinated alkyl group.

The alkyl group having no substituent or the halogenated alkyl group of R³⁵ preferably has 1 or more and 10 or less carbon atoms, more preferably 1 or more and 8 or less carbon atoms, and most preferably 1 or more and 6 or less carbon atoms. As R³⁵, a halogenated alkyl group is preferred, and a fluorinated alkyl group is more preferred. In the fluorinated alkyl group in R³³, it is preferable that 50% or more, 70% or more, and most preferably 90% or more of the hydrogen atoms are fluorinated, because acid strength of generated acid is increased. Most preferably, the fluorinated alkyl group in R³³ is a fully fluorinated alkyl group, in which 100% of hydrogen atoms are fluorinated.

In formula (a8), examples of the alkyl group having no substituent or the halogenated alkyl group as R³⁶ include the same groups as the alkyl groups or the halogenated alkyl group that have no substituents and that are exemplified for R³³ above. Examples of the di- or tri-valent aromatic hydrocarbon group as R³⁷ include a group obtained by removing 1 or 2 hydrogen atoms from the aryl group as R³⁴ described above. Examples of the alkyl group having no substituent or the halogenated alkyl group as R³⁸ include the same groups as the alkyl groups or the halogenated alkyl groups having no substituent that have no substituents and that are exemplified for R³⁵ described above. p" is preferably 2.

Specific examples of oxime sulfonate-based acid generators include: α-(p-toluenesulfonyloxyimino)-benzyl cyanide, α-(p-chlorobenzenesulfonyloxyimino)-benzyl cyanide, α-(4-nitrobenzenesulfonyloxyimino)-benzyl cyanide, α-(4-nitro-2-trifluoromethylbenzenesulfonyloxyimino)-benzyl cyanide, α-(benzenesulfonyloxyimino)-4-chlorobenzyl cyanide, α-(benzenesulfonyloxyimino)-2,4-dichlorobenzyl cyanide, α-(benzenesulfonyloxyimino)-2,6-dichlorobenzyl cyanide, α-(benzenesulfonyloxyimino)-4-methoxybenzyl cyanide, α-(2-chlorobenzenesulfonyloxyimino)-4-methoxybenzyl cyanide, α-(benzenesulfonyloxyimino)-thien-2-ylacetonitrile, α-(4-dodecylbenzenesulfonyloxyimino)-benzyl cyanide, α-[(p-toluenesulfonyloxyimino)-4-methoxyphenyl]acetonitrile, α-[(dodecylbenzenesulfonyloxyimino)-4-methoxyphenyl]acetonitrile, α-(tosyloxyimino)-4-thienyl cyanide, α-(methylsulfonyloxyimino)-1-cyclopentenylacetonitrile, α-(methylsulfonyloxyimino)-1-cyclohexenylacetonitrile, α-(methylsulfonyloxyimino)-1-cycloheptenylacetonitrile, α-(methylsulfonyloxyimino)-1-cyclooctenylacetonitrile, α-(trifluoromethylsulfonyloxyimino)-1-cyclopentenyl acetonitrile, α-(trifluoromethylsulfonyloxyimino)-cyclohexylacetonitrile, α-(ethylsulfonyloxyimino)-ethylacetonitrile, α-(propylsulfonyloxyimino)-propylacetonitrile, α-(cyclohexylsulfonyloxyimino)-cyclopentylacetonitrile, α-(cyclohexylsulfonyloxyimino)-cyclohexylacetonitrile, α-(cyclohexylsulfonyloxyimino)-1-cyclopentenylacetonitrile, α-(ethylsulfonyloxyimino)-1-cyclopentenylacetonitrile, α-(isopropylsulfonyloxyimino)-1-cyclopentenylacetonitrile, α-(n-butylsulfonyloxyimino)-1-cyclopentenylacetonitrile, α-(ethylsulfonyloxyimino)-1-cyclohexenylacetonitrile, α-(isopropylsulfonyloxyimino)-1-cyclohexenylacetonitrile, α-(n-butylsulfonyloxyimino)-1-cyclohexenylacetonitrile, α-(methylsulfonyloxyimino)-phenylacetonitrile, α-(methylsulfonyloxyimino)-p-methoxyphenylacetonitrile, α-(trifluoromethylsulfonyloxyimino)-phenylacetonitrile, α-(trifluoromethylsulfonyloxyimino)-p-methoxyphenylacetonitrile, α-(ethylsulfonyloxyimino)-p-methoxyphenylacetonitrile, α-(propylsulfonyloxyimino)-p-methylphenylacetonitrile, α-(methylsulfonyloxyimino)-p-bromophenylacetonitrile, etc. In addition, oxime sulfonate-based acid generators disclosed in Japanese Unexamined Patent Application, Publication No.H09-208554 ([Chemical Formula 18] to [Chemical Formula 19] of paragraphs [0012] to [0014]), and oxime sulfonate-based acid generators disclosed in International Publication No. WO2004/074242A2 (Examples 1 to 40 on pages 65 to 85) also can be suitably used. Further, the following compounds can be exemplified as suitable oxime sulfonate-based acid generators.

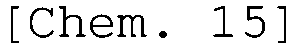

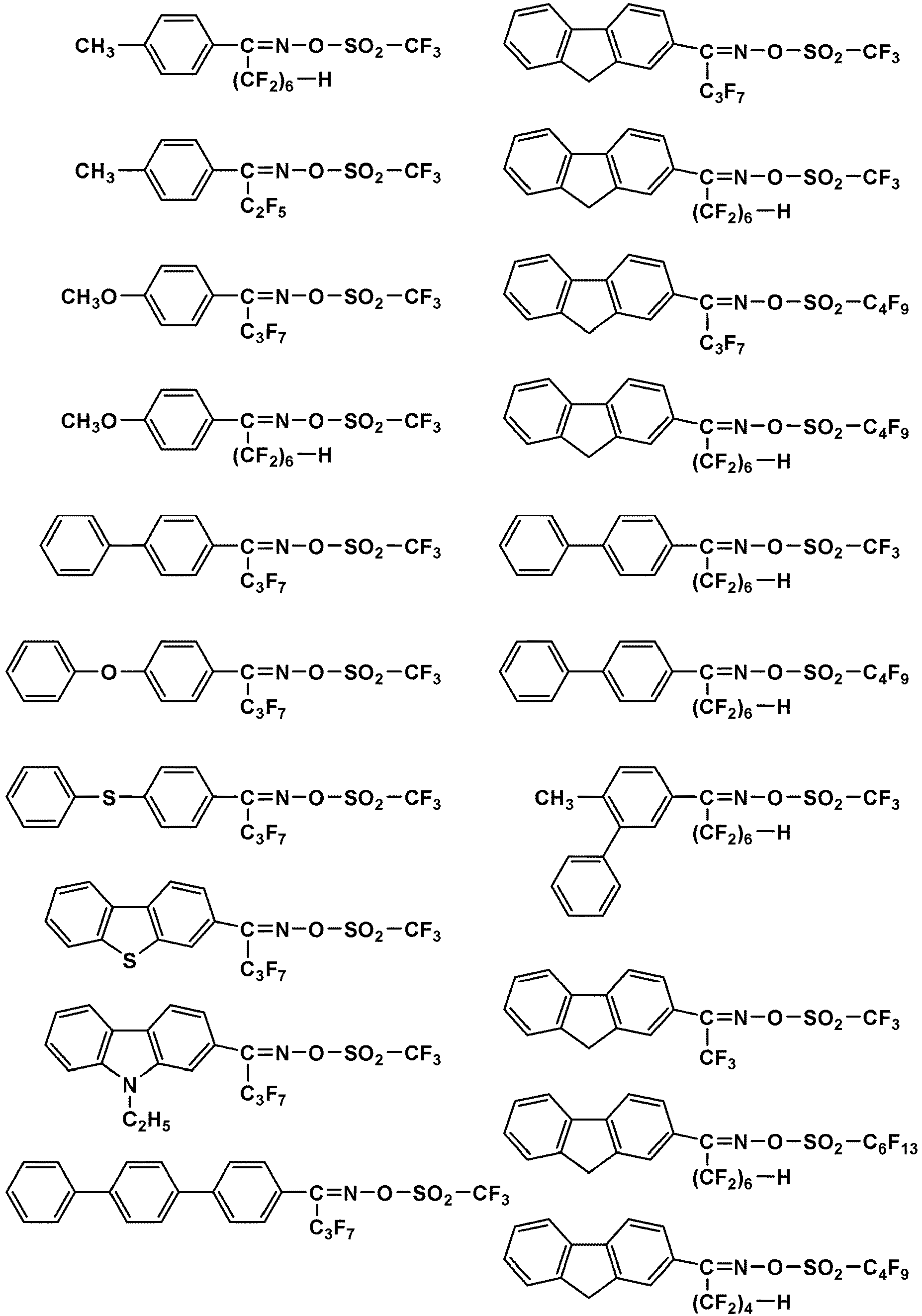

Among the above exemplified compounds, the following four compounds are preferred.

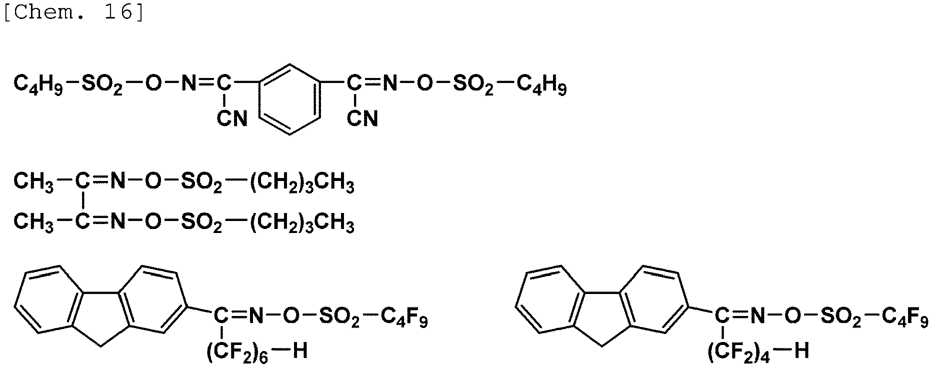

Among diazomethane-based acid generators, specific examples of bisalkyl- or bisaryl-sulfonyldiazomethanes include bis(isopropylsulfonyl)diazomethane, bis(p-toluenesulfonyl)diazomethane, bis(1,1-dimethylethylsulfonyl)diazomethane, bis(cyclohexylsulfonyl)diazomethane, and bis(2,4-dimethylphenylsulfonyl)diazomethane, etc. Further, diazomethane-based acid generators disclosed in Japanese Unexamined Patent Application, Publication Nos. H11-035551, H11-035552, and H11-035573 can also be suitably used. Further, examples of the poly(bissulfonyl) diazomethanes include 1,3-bis (phenylsulfonyldiazomethylsulfonyl)propane, 1,4-bis (phenylsulfonyldiazomethylsulfonyl)butane, 1,6-bis (phenylsulfonyldiazomethylsulfonyl)hexane, 1,10-bis (phenylsulfonyldiazomethylsulfonyl)decane, 1,2-bis (cyclohexylsulfonyldiazomethylsulfonyl)ethane, 1,3-bis(cyclohexylsulfonyldiazomethylsulfonyl)propane, 1,6-bis(cyclohexylsulfonyldiazomethylsulfonyl)hexane, 1,10-bis(cyclohexylsulfonyldiazomethylsulfonyl)decane, etc.

As the acid generator, one type of these may be used singly, or two or more types thereof may be used in combination. Among the above, the oxime sulfonate-based acid generators are excellent in transparency, have high performance as an acid generator, and have good solubility in an organic solvent. The content of the acid generator in an energy-sensitive composition is preferably 1 part by mass or more and 10 parts by mass or less, and more preferably 2 parts by mass or more and 5 parts by mass or less, per 100 parts by mass of organopolysiloxane. When the content is equal to or higher than the lower limit value of the above range, an effect by blending the acid generator is sufficiently obtained, and when the content is equal to or lower than the upper limit value, a uniform solution is obtained when the composition is dissolved in an organic solvent, and storage stability is good, which is preferable.

The energy-sensitive composition may further contain a crosslinking agent as an optional component within a range not impairing the effect of the present invention. By containing a crosslinking agent, heat resistance is further improved. The crosslinking agent is desirably a component that is capable of forming a crosslinked structure in organopolysiloxane or in the crosslinking agent by the action of heat and/or ultraviolet rays. Examples of the crosslinking agent include a compound having an epoxy group and/or an oxetane group. Specific examples thereof include various types of epoxy resin and a copolymer of a polymerizable unsaturated compound including an epoxy group-containing polymerizable unsaturated compound.

Examples of the epoxy resin include epoxy resins described in Japanese Unexamined Patent Application, Publication No. H08-262709. Preferably, examples thereof include bisphenol A type epoxy resins, phenol novolac type epoxy resins, cresol novolac type epoxy resins, cyclic aliphatic epoxy resins, glycidyl ester type epoxy resins, glycidylamine type epoxy resins, heterocyclic epoxy resins, resins obtained by (co) polymerizing glycidyl methacrylate, etc. Among these, bisphenol A type epoxy resins, cresol novolac type epoxy resins, glycidyl ester type epoxy resins, etc. are preferred.

Examples of the epoxy group-containing polymerizable unsaturated compound include a compound having a vinyl group and an epoxy group. Specific examples include glycidyl acrylate, glycidyl methacrylate, glycidyl α-ethylacrylate, glycidyl α-n-propylacrylate, glycidyl α-n-butylacrylate, 3,4-epoxybutyl acrylate, 3,4-epoxybutyl methacrylate, 6,7-epoxyheptyl acrylate, 6,7-epoxyheptyl methacrylate, 6,7-epoxyheptyl α-ethylacrylate, N-[4-(2,3-epoxypropoxy)-3,5-dimethylbenzyl]acrylamide, N-[4-(2,3-epoxypropoxy)-3,5-dimethylphenylpropyl]acrylamide, β-methylglycidyl acrylate, β-methylglycidyl methacrylate, o-vinylbenzyl glycidyl ether, m-vinylbenzyl glycidyl ether, p-vinylbenzyl glycidyl ether, etc. Examples of a polymerizable unsaturated compound that is used together with an epoxy group-containing polymerizable unsaturated compound in the 'copolymer of a polymerizable unsaturated compound including an epoxy group-containing polymerizable unsaturated compound' include a compound having a polymerizable unsaturated bond and having no epoxy group. Specific examples thereof include acrylic acid, methacrylic acid, acrylate esters, acrylamides, methacrylate esters, methacrylamides, allyl compounds, vinyl ethers, vinyl esters, styrenes, crotonate esters, etc. Among these, acrylic acid, methacrylic acid, acrylate esters, and methacrylate esters are preferred, acrylic acid and methacrylic acid are particularly preferred, and methacrylic acid is further preferred. A proportion of the epoxy group-containing polymerizable unsaturated compound in the polymerizable unsaturated compound used in the copolymer is desirably 5 mol% or more and 90 mol% or less, and preferably 50 mol% or more and 85 mol% or less.

Further, it is preferable that the crosslinking agent has an alicyclic epoxy group. As the crosslinking agent, a copolymer of a polymerizable unsaturated compound including an alicyclic epoxy group-containing polymerizable unsaturated compound is particularly preferred. The alicyclic epoxy group refers to a group formed by -O- bonding to two adjacent carbon atoms that constitute a ring of the aliphatic cyclic group, to form a ring. The number of carbon atoms of the alicyclic group of the alicyclic epoxy group is preferably about 5 or more and 10 or less. Examples of the alicyclic epoxy group-containing polymerizable unsaturated compound include compounds represented by formulas (2) to (32) disclosed in, for example, Japanese Unexamined Patent Application, Publication No. H08-262709.

Further, as the crosslinking agent, in addition to the above, crosslinking agents commonly used in resist compositions can be used. Examples of the crosslinking agent include alicyclic hydrocarbons having a hydroxy group or a hydroxyalkyl group or both or oxygen-containing derivatives thereof, such as 2,3-dihydroxy-5-hydroxymethylnorbornane, 2-hydroxy-5,6-bis(hydroxymethyl)norbornane, cyclohexanedimethanol, 3,4,8 (or 9)-trihydroxytricyclodecane, 2-methyl-2-adamantanol, 1,4-dioxane-2,3-diol, 1,3,5-trihydroxycyclohexane, and the like. Further, examples thereof include a compound obtained by reacting an amino group-containing compound such as melamine, acetoguanamine, benzoguanamine, urea, ethylene urea, propylene urea, or glycoluril with formaldehyde, or with formaldehyde and a lower alcohol, to replace a hydrogen atom of the amino group by a hydroxymethyl group or a lower alkoxymethyl group. Among these, a crosslinking agent using melamine is referred to as a melamine-based crosslinking agent, a crosslinking agent using urea is referred to as a urea-based crosslinking agent, a crosslinking agent using alkylene urea such as ethylene urea or propylene urea is referred to as an alkylene urea-based crosslinking agent, and a crosslinking agent using glycoluril is referred to as a glycoluril-based crosslinking agent.

Examples of the melamine-based crosslinking agent include a compound obtained by reacting melamine with formaldehyde, to replace a hydrogen atom of an amino group with a hydroxymethyl group; a compound obtained by reacting melamine, formaldehyde, and a lower alcohol to replace a hydrogen atom of an amino group with a lower alkoxymethyl group, and the like. Specific examples thereof include hexamethoxymethylmelamine, hexaethoxymethylmelamine, hexapropoxymethylmelamine, hexabutoxybutylmelamine, and the like, and among others, hexamethoxymethylmelamine is preferred. Examples of the urea-based crosslinking agent include a compound obtained by reacting urea with formaldehyde, to replace a hydrogen atom of an amino group with a hydroxymethyl group; a compound obtained by reacting urea, formaldehyde, and a lower alcohol to replace a hydrogen atom of an amino group with a lower alkoxymethyl group, and the like. Specific examples include bismethoxymethylurea, bisethoxymethylurea, bispropoxymethylurea, bisbutoxymethylurea, and the like, and bismethoxymethylurea is preferable among others. Examples of the alkylene urea-based crosslinking agent include a compound obtained by subjecting an alkylene urea and formalin to a condensation reaction, and also a compound obtained by reacting the product of the condensation reaction with a lower alcohol. Specific examples include an ethylene urea-based crosslinking agent, such as mono- and/or dihydroxymethylated ethyleneurea, mono- and/or dimethoxymethylated ethyleneurea, mono- and/or diethoxymethylated ethyleneurea, mono- and/or dipropoxymethylated ethyleneurea, mono- and/or dibutoxymethylated ethyleneurea, etc.; a propylene urea-based crosslinking agent, such as mono- and/or dihydroxymethylated propyleneurea, mono- and/or dimethoxymethylated propyleneurea, mono- and/or diethoxymethylated propyleneurea, mono- and/or dipropoxymethylated propyleneurea, mono- and/or dibutoxymethylated propyleneurea, etc.; 1,3-di(methoxymethyl)-4,5-dihydroxy-2-imidazolidinone; 1,3-di(methoxymethyl)-4,5-dimethoxy-2-imidazolidinone, etc. Examples of the glycoluril-based crosslinking agent include a glycoluril derivative obtained by substituting an N-position with one of a hydroxyalkyl group and an alkoxyalkyl group having 1 or more and 4 or less carbon atoms or substituting with both of them. Such a glycoluril derivative can be obtained by condensation reaction of glycoluril and formalin, or by reacting this product with a lower alcohol. Specific examples include mono, di, tri and/or tetrahydroxymethylated glycoluril, mono, di, tri and/or tetramethoxymethylated glycoluril, mono, di, tri and/or tetraethoxymethylated glycoluril, mono, di, tri and/or tetrapropoxymethylated glycoluril, mono, di, tri and/or tetrabutoxymethylated glycoluril, and the like.

The crosslinking agent may be used singly or as a mixture of two or more types thereof. The amount of the crosslinking agent to be blended is preferably 5 parts by mass or more and 100 parts by mass or less, more preferably 10 parts by mass or more and 50 parts by mass or less, per 100 parts by mass of organopolysiloxane. When the blending amount of the crosslinking agent is within this range, a heat resistance improving effect is further improved.

The energy-sensitive composition may contain various additives such as a surfactant, a sensitizer, a defoaming agent, an ultraviolet absorber, a storage stabilizer, an additional resin, a plasticizer, a stabilizer, a contrast improver, and the like within a range not impairing the effect of the present invention. The surfactant may be a conventionally known surfactant, and examples thereof include compounds such as an anionic type compound, a cationic type compound, and a nonionic compound. Specifically, X-70-090 (product name, manufactured by Shin-Etsu Chemical Co., Ltd.) and the like can be mentioned. As the sensitizer, a sensitizer used in conventionally known positive resists can be used. Examples thereof include a compound having a phenolic hydroxy group and having a molecular weight of 1000 or less. As the defoaming agent, a conventionally known defoaming agent may be used, and examples thereof include a silicone-based compound and a fluorine-based compound.

The energy-sensitive composition can be produced by dissolving the above components in an organic solvent. As the organic solvent, any organic solvent that dissolves each component to be used and provides a uniform solution can be used. As the organic solvent (S), for example, one or two or more can be appropriately selected from any organic solvent conventionally known as a resist solvent and used. Specific examples include lactones such as γ-butyrolactone, etc.;
ketones such as acetone, methyl ethyl ketone, cyclohexanone, methyl-n-pentyl ketone, methyl isopentyl ketone, 2-heptanone, etc.;
polyhydric alcohols such as ethylene glycol, diethylene glycol, propylene glycol, dipropylene glycol, etc.;
compounds having an ester bond such as ethylene glycol monoacetate, diethylene glycol monoacetate, propylene glycol monoacetate, or dipropylene glycol monoacetate, etc.,
derivatives of polyhydric alcohols, such as compounds having an ether bond, such as a monoalkyl ether (e.g., monomethyl ether, monoethyl ether, monopropyl ether, monobutyl ether, etc.) or a mono-phenyl ether of the polyhydric alcohols or the compounds having an ester bond [among these, propylene glycol monomethyl ether acetate (PGMEA) and propylene glycol monomethyl ether (PGME) are preferred];
cyclic ethers such as dioxane and esters such as methyl lactate, ethyl lactate (EL), methyl acetate, ethyl acetate, butyl acetate, methyl pyruvate, ethyl pyruvate, methyl methoxypropionate, ethyl ethoxypropionate, etc.; and
aromatic organic solvents such as anisole, ethylbenzyl ether, cresyl methyl ether, diphenyl ether, dibenzyl ether, phenetol, butyl phenyl ether, ethylbenzene, diethylbenzene, pentylbenzene, isopropylbenzene, toluene, xylene, cymene, mesitylene, etc., and the like. These organic solvents may be used singly, or may be used as a mixed solvent of two or more types. Among these, propylene glycol monomethyl ether acetate (PGMEA), propylene glycol monomethyl ether (PGME), and EL are preferable. A mixed solvent in which PGMEA and a polar solvent are mixed is also preferred. The blending ratio (mass ratio) thereof may be appropriately determined in consideration of compatibility, etc. between PGMEA and the polar solvent, but is preferably set within a range of 1:9 to 9:1, and more preferably 2:8 to 8:2. More specifically, when EL is blended as a polar solvent, the mass ratio of PGMEA : EL is preferably from 1:9 to 9:1, and more preferably from 2:8 to 8:2. In addition, when PGME is blended as a polar solvent, the mass ratio of PGMEA : PGME is preferably 1:9 to 9:1, more preferably 2:8 to 8:2, and most preferably 3:7 to 7:3. Further, as another organic solvent, a mixed solvent of at least one selected from PGMEA and EL with γ-butyrolactone is also preferred. In this case, as the mixing ratio, the mass ratio of the former and the latter is preferably set to 70:30 to 95:5. The amount of the organic solvent to be used is not particularly limited, and is appropriately set depending upon the coating film thickness at a concentration which can be applied on the semiconductor substrate to be processed. The organic solvent (S) is usually used in an amount in which the solid component concentration in the composition is within a range of 10% by mass or more and 50% by mass or less, and preferably 15% by mass or more and 35% by mass or less.

### (Formation of mask)

A mask is formed on the above-mentioned semiconductor substrate to be processed using the energy-sensitive composition containing the above defined organopolysiloxane. Although there is no particular limitation on the method of forming a mask, for example, a mask can be formed by the following method.

First, an energy-sensitive composition containing the organopolysiloxane is applied to a surface of a semiconductor substrate to be processed, using a spinner, a roll coater, a spray, or the like, and dried, if necessary, to form a coating film. There is no particular limitation on the drying method, and examples thereof include a method of drying at a temperature of 80°C or more and 150°C or less for 30 seconds or more and 120 seconds or less on a hot plate, a method of leaving the semiconductor substrate to be processed at room temperature for several hours to several days, and a method of removing a solvent by putting the semiconductor substrate to be processed in a hot air heater or an infrared heater for several ten minutes to several hours. The film thickness of the coating film is not particularly limited and may be appropriately set. Normally, the coating film is formed so that the film thickness from an upper end portion of the semiconductor substrate to be processed to an upper surface of the coating film is 1 um or more and 10 um or less.

Next, the coating film is selectively irradiated (exposed) with radiation such as visible light, ultraviolet light, excimer laser light, or the like. During exposure, a molecular structure of the photosensitizing agent changes at a portion irradiated with radiation, so that solubility in an aqueous alkali solution is increased. Thus, in the next step, when development is performed with a developer (an aqueous alkali solution), a portion of the coating film after exposure, which has been made soluble by exposure, is selectively dissolved and removed to form a patterned film as a mask. Exposure conditions are not particularly limited. Depending on the light source and method used for exposure, the exposure area, exposure time, exposure intensity, and the like can be appropriately selected. The exposure light source is not particularly limited, and may be performed using radiation such as g-line (436 nm), h-line (405 nm), i-line (365 nm), KrF excimer laser, ArF excimer laser, F₂ excimer laser, EUV (extreme ultraviolet ray), VUV (vacuum ultraviolet ray), EB (electron beam), X-ray, soft X-ray, and the like. In particular, g-line (436 nm), h-line (405 nm) or i-line (365 nm) is preferred, and g-line or i-line is more preferred. After exposure, post exposure bake (PEB) for 40 seconds or more and 120 seconds or less may be performed under temperature conditions of, for example, 80°C or more and 150°C or less.

Then, the coating film (cured film) after exposure is developed using an alkali developer. Examples of the alkali developer include an aqueous organic alkali solution such as 0.1% by mass or more and 10% by mass or less aqueous tetramethylammonium hydroxide solution, or an aqueous inorganic alkali solution of sodium hydroxide, potassium hydroxide, sodium metasilicate, sodium phosphate, or the like.

After development, it is preferable to perform an ultraviolet curing treatment before performing burning, which is described below. Thereby, heat resistance is improved and deformation during burning can be suppressed. The reason why such an effect is obtained is not clear, but it is presumed that the photosensitizing agent functions as a crosslinking agent and forms crosslinks between molecules of the organopolysiloxane. The ultraviolet curing treatment can be performed using a known method. For example, the ultraviolet curing treatment can be carried out by irradiating the entire surface with ultraviolet rays, using a known ultraviolet irradiation device (e.g., Deep UV Processor Lamp L-800FS manufactured by Nippon Denchi Kabushiki Kaisha, excimer light irradiation device SCG01 manufactured by Ushio Inc.). In the ultraviolet irradiation, it is preferable to use a light source which mainly outputs ultraviolet rays having a wavelength of 400 nm or less, particularly a wavelength of 150 nm or more and 300 nm or less. Examples of such a light source include lamp L-800FS manufactured by Nippon Denchi Kabushiki Kaisha (main wavelength: 254 nm, 185 nm); lamp UEM50L-172A/x4 (main wavelength: 172 nm) manufactured by Ushio Inc., etc. The ultraviolet ray is preferably irradiated with an irradiation dose of about 500 mJ/cm² or more and 20,000 mJ/cm² or less, and more preferably, 1,000 mJ/cm² or more and 15,000 mJ/cm² or less. The irradiation dose can be controlled by the intensity of ultraviolet rays to be irradiated and the irradiation time. Note that, when carrying out irradiation with ultraviolet rays, it is desirable to suppress rapid irradiation or an increase in temperature due to irradiation so as not to generate wrinkles in the irradiated portion.

After the ultraviolet curing treatment, post-baking may be performed before the heat curing treatment (burning treatment). Although this post-baking treatment is not necessarily required, heat resistance is further improved by performing the post-baking. Further, adhesion to the semiconductor substrate to be processed is improved by the post-baking treatment. As the post-baking treatment, a heat treatment at a temperature of 60°C or more and 230°C or less for about 1 minute or more and 10 minutes or less is preferable. Note that, since the heat resistance is improved by the ultraviolet curing treatment, deformation does not easily occur during the post-baking step.

Next, a heat curing treatment (burning treatment) is performed. Thereby, a film having a pattern shape (patterned mask) containing SiO₂ as a main component is formed. This mask is highly transparent to visible light because the main component is SiO₂. Further, it is also possible to have insulating property (e.g., insulating property in which dielectric constant at 1 MHz is within the range of 3.5 or more 5 or less). Heating temperature is, for example, 700°C or less, and preferably 250°C or higher 600°C or less. Further, it is preferable that the heat curing treatment is performed in a nitrogen atmosphere. The heating time also varies depending on the heating temperature, but is usually preferably 10 minutes or more and 60 minutes or less, and more preferably 15 minutes or more and 30 minutes or less.

### <Ion implantation step>

In the ion implantation step, ion implantation is performed to a semiconductor substrate to be processed comprising the mask formed in the mask formation step. By the ion implantation, impurity regions are formed in accordance with a pattern shape of the mask on the surface side of the semiconductor substrate to be processed, and a semiconductor substrate having a mask is manufactured.

Ion species to be implanted into the semiconductor substrate to be processed by ion implantation are not limited, and examples thereof include aluminum, boron, gallium, indium, nitrogen, phosphorus, arsenic, and antimony.

The method of ion implantation is not particularly limited, and known methods can be used. For example, ions of a target element may be collided with a semiconductor substrate to be processed, while heating the semiconductor substrate to be processed as necessary. A compound containing ions of a target element may be exposed to the semiconductor substrate to be processed, while heating the semiconductor substrate to be processed as necessary.

Heating temperature of the semiconductor substrate to be processed is, for example, 300°C or higher 600°C or less. Ion dose is, for example, 1×10¹⁰ cm⁻² or more and 1×10²⁰ cm⁻² or less. It is preferable to apply bias to ions and accelerate them to collide with the substrate, and the acceleration energy of ions is, for example, 1 keV or more and 10,000 keV or less.

### <Mask removal step>

In the mask removal step, a mask is removed. The mask removal step consists of a first step including at least one of:
contacting the mask with a first treatment liquid containing an oxidizing agent and
irradiating the mask with plasma generated using an oxygen-containing gas, and
a second step including bringing the mask after being subjected to the first step into contact with a second treatment liquid containing fluoride ions, wherein the temperature of the semiconductor substrate in the mask removal step is 200°C or less.

### (Step 1)

In the first step, the mask and the first treatment liquid containing an oxidizing agent are brought into contact with each other, or the mask is irradiated with a plasma generated using an oxygen-containing gas. In the first step, the mask and the first treatment liquid containing an oxidizing agent may be brought into contact with each other, and the mask may be further irradiated with plasma generated using an oxygen-containing gas. In the first step, it is preferable that the mask and the first treatment liquid containing an oxidizing agent are brought into contact with each other.

The first treatment liquid used when the mask and the first treatment liquid are brought into contact with each other includes an oxidizing agent. The oxidizing agent is not particularly limited as long as it can oxidize at least a part of the mask. The first treatment liquid preferably contains at least one of sulfuric acid and hydrochloric acid and at least one of hydrogen peroxide and ozone as an oxidizing agent, more preferably contains at least one of sulfuric acid and hydrochloric acid and hydrogen peroxide, and more preferably contains sulfuric acid and hydrogen peroxide. The mass ratio of the total amount of sulfuric acid and hydrochloric acid to hydrogen peroxide is, for example, 4:1 to 1:4.

The method of bringing the first treatment liquid into contact with the mask is not particularly limited, and for example, the mask may be immersed in the first treatment liquid while adhering to the semiconductor substrate, or the first treatment liquid may be applied to the mask surface by a coating method such as a spin coating method, a spraying method, or a roller coating method. Although conditions for bringing the first treatment liquid into contact with the mask are not particularly limited, for example, the temperature of the first treatment liquid is 50°C or more and 200°C or less, and the contact time between the first treatment liquid and the mask is 1 minute or more and 1 hour or less.

When plasma is radiated to the mask, the plasma is generated using an oxygen-containing gas. The oxygen-containing gas may be oxygen alone, and may be a mixed gas of oxygen and a gas other than oxygen such as fluoromethane, ozone, argon, chlorine, etc. The oxygen-containing gas is preferably a gas containing oxygen in a content of 50% by volume or more.

Irradiation conditions of plasma are not particularly limited as long as at least a part of the mask can be oxidized. For example, bias applied is 10 W or more and 500 W or less, pressure is 1 Pa and more and 15 Pa or less, high frequency output (RF) is 100 W or more and 2,000 W or less, and plasma irradiation time is 3 minutes or more and 100 minutes or less. Further, the temperature of the semiconductor substrate during plasma irradiation is 200°C or less, and preferably 100°C or less.

### (Step 2)

In the second step, a second treatment liquid containing fluoride ions is contacted with the mask after being subjected to the first step. The second treatment liquid used in the second step includes fluoride ions. Examples of the second treatment liquid include a solution containing a compound that generates fluoride ions, such as an aqueous solution containing hydrogen fluoride, lithium fluoride, sodium fluoride, potassium fluoride, magnesium fluoride, calcium fluoride, strontium fluoride, barium fluoride, ammonium fluoride, aluminum fluoride, or zinc fluoride. It is preferable that the second treatment liquid contains hydrogen fluoride or a salt thereof (hydrofluoric acid or a salt thereof). In the second treatment liquid, the content of hydrogen fluoride or a salt thereof is, for example, 5% by mass or more, preferably 8% by mass or more, more preferably 10% by mass or more, and most preferably 15% by mass or more. There is no particular limit on the upper limit value, and the upper limit is, for example, 80% by mass or less. Further, as this second treatment liquid, a commercially available solution containing a hydrofluoric acid or a commercially available solution containing a salt of hydrofluoric acid can also be used. Typical examples include 10:1 SA High Purity Buffered Hydrofluoric Acid manufactured by Stella Chemiphar Corporation.

The method of bringing the second treatment liquid into contact with the mask is not particularly limited, and for example, the mask after being subjected to the first step may be immersed in the second treatment liquid while adhering to the semiconductor substrate, or the second treatment liquid may be applied to the surface of the mask after being subjected to the first step by a coating method such as a spin coating method, a spraying method, or a roller coating method. Although conditions for bringing the second treatment liquid into contact with the mask are not particularly limited, for example, the contact time between the second treatment liquid and the mask is 1 minute or more and 1 hour or less and the temperature of the second treatment liquid is 50°C or less.

As described above, by performing the above-described specific first and second steps in this order, organic substances are mainly removed in the first step, and components mainly originating from silicon are removed in the second step, so that an ion implantation mask which is formed using a composition containing an organopolysiloxane can be satisfactorily removed (peeled off). Thus, it is possible to manufacture a semiconductor substrate having less mask residue or no mask residue.

In the mask removal step, conditions are employed under which the semiconductor substrate is not heated to a high temperature. A condition under which the semiconductor substrate in the mask removal step is at a temperature of 200°C or below is adopted. In such a case, since the semiconductor substrate is not exposed to an overly high temperature in the mask removal step, there is an advantage that diffusion of dopants implanted during the ion implantation step due to heating can be suppressed. Further, there is an advantage that the dopant concentration in an impurity region formed according to the pattern shape of the mask can be maintained before and after the mask removal step, and an undesired increase in the dopant concentration in the region other than the impurity region can be suppressed. Thus, it is possible to manufacture a semiconductor substrate in which an impurity region containing dopants at a desired concentration is formed in a desired region. The temperature of the semiconductor substrate in the mask removal step is 200°C or less, and preferably 100°C or less.

After the mask removal step, the semiconductor substrate may be cleaned by subjecting the semiconductor substrate to ultraviolet irradiation, plasma irradiation, chemical treatment, ultrasonic treatment, etc., if necessary.

The semiconductor substrate manufactured by the above manufacturing method can be applied to semiconductor substrates for manufacturing various semiconductor devices.

### EXAMPLES

Hereinafter, the present invention is described in more detail based on the Examples, but the present invention is not limited by these Examples.

### (Preparation of energy-sensitive composition)

Energy-sensitive composition 1 was prepared by mixing 100 parts by mass of the following organopolysiloxane 1, 20 parts by mass of photosensitizing agent 1, and 400 parts by mass of propylene glycol monomethyl ether acetate (PGMEA). 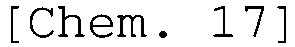 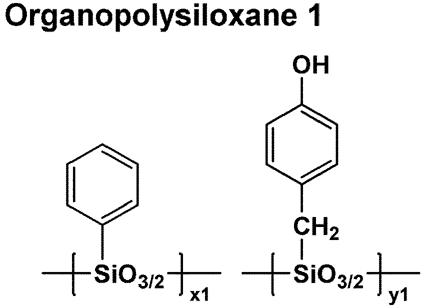 x1 : y1 = 30 : 70 (molar ratio)
Mass-average molecular weight Mw = 8,500 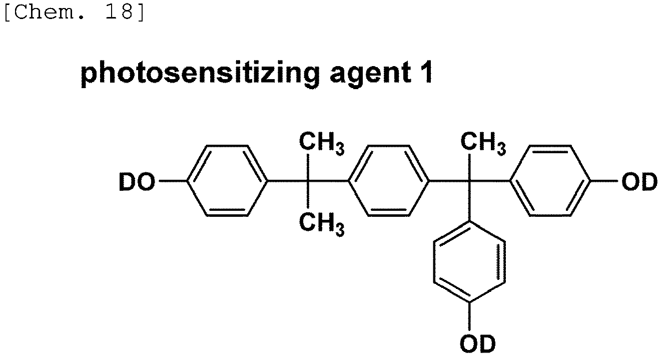 in which D represents a naphthoquinone-1,2-diazidesulfonyl group.

### [Example 1]

### <Mask formation step>

A coating film having a film thickness of 2.0 um was formed by coating energy-sensitive composition 1 on a silicon substrate surface by a spin coating method and performing a heat treatment (drying treatment) on a hot plate at 90°C for 60 seconds. Next, exposure was performed to the coating film via a mask by an exposure machine (manufactured by Nikon Corporation, product name: NSR-G7, NA = 0.54), and then a heat treatment (PEB) was performed on a hot plate at 90°C for 60 seconds. After PEB, development was performed using an aqueous solution of tetramethylammonium hydroxide (TMAH) having a concentration of 2.38% by mass for 120 seconds, and the obtained substrate was rinsed with pure water. Next, ultraviolet rays were radiated using a high-pressure mercury lamp (manufactured by Nippon Denchi Kabushiki Kaisha, product name: Deep UV Processor lamp L-800FS, main wavelength: 254, 185 nm; irradiation dose: 2,700 mJ/cm²) to perform an ultraviolet curing treatment. Next, after the UV curing treatment, a heat curing treatment was performed at 500°C for 30 minutes in a nitrogen atmosphere using a vertical bake oven (TOK TS8000MB) to form a mask to be used for ion implantation on the silicon substrate. The mask formed had a line and space pattern having a line width of 1.2 um and a line and space pattern having a line width of 30 um.

### <Ion implantation step>

Ion implantation was performed to the silicon substrate provided with the mask obtained in the mask formation step, using an ion implantation device (product name: IMPHEAT, manufactured by Nissin Ion Equipment Co., Ltd.) under conditions of ion species: Al, acceleration energy: 300 keV, ion dose: 1 × 10¹⁵ cm⁻², and ion implantation temperature: 500°C, to form impurity regions.

<Mask removal step>

First, the mask was immersed in the first treatment liquid (sulfuric acid: hydrogen peroxide = 3:1 (mass ratio)) at 120°C for 10 minutes together with the silicon substrate having an impurity region formed therein (first step). Thereafter, the mask was immersed in the second treatment liquid (10:1 SA high-purity buffered hydrofluoric acid (manufactured by Stella Chemifa Co., Ltd.)) at 25°C for 5 minutes together with the silicon substrate having an impurity region formed therein (second step), to obtain a semiconductor substrate.

### [Examples 2 to 3 and Comparative Example 1]

Semiconductor substrates were obtained in the same manner as in Example 1, except that the temperature of the first treatment liquid in the first step of the mask removal step was changed to the conditions shown in Table 1. Note that, in Comparative Example 1, the first step was not performed.

### [Examples 4 to 15]

Semiconductor substrates were obtained in the same manner as in Example 1, except that the first step of the mask removal step was changed to an operation in which plasma was radiated onto the silicon substrate having an impurity region formed therein under the conditions described in Table 2, using a plasma irradiation device (manufactured by RIE-101iPH, manufactured by SUMCO Co., Ltd.). Incidentally, a stage temperature was set to 25°C and pressure was set to 10 Pa.

### <Observation of semiconductor substrate surface (residue evaluation)>

The surfaces of the semiconductor substrates obtained in the Examples and Comparative Examples were observed by a metal microscope (manufactured by Olympus Co., Ltd., product name MX-61), to observe residues of the masks of ion implantation and evaluate the residues, based on the following criteria. The results are given in Table 1.
⊚: No mask residue was observed in either of the line and space pattern with a line width of 30 um or the line and space pattern with a line width of 1.2 um.
O: No mask residue was observed in the line and space pattern with a line width of 30 um, but mask residue was slightly observed in the line and space pattern with a line width of 1.2 um.
X: Mask residue was observed in both of the line and space pattern with a line width of 30 um and the line and space pattern with a line width of 1.2 um.

**[Table 1]**

| | Temperature of the first treatment liquid (°C) | Residue |
|---|---|---|
| Example 1 | 120 | ○ |
| Example 2 | 140 | ○ |
| Example 3 | 160 | ⊚ |
| Comparative Example 1 | - | × |

**[Table 2]**

| | RF (W) | Bias (W) | Type/flow rate of gas (sccm) | Irradiation time (Minute) | Residue |
|---|---|---|---|---|---|
| Example 4 | 400 | 50 | O₂/50 | 30 | ○ |
| Example 5 | 400 | 50 | O₂/50 | 60 | ○ |
| Example 6 | 1000 | 50 | O₂/50 | 10 | ○ |
| Example 7 | 1000 | 50 | O₂/50 | 30 | ⊚ |
| Example 8 | 1000 | 200 | O₂/50 | 10 | ⊚ |
| Example 9 | 1000 | 300 | O₂/50 | 10 | ⊚ |
| Example 10 | 1000 | 300 | O₂/50 | 5 | ○ |
| Example 11 | 1000 | 300 | O₂/50 | 10 | ⊚ |
| | | | CHF₃/1 | | |
| Example 12 | 500 | 200 | O₂/50 | 10 | ⊚ |
| | | | CHF₃/5 | | |
| Example 13 | 500 | - | O₂/50 | 10 | ⊚ |
| | | | CHF₃/5 | | |
| Example 14 | 500 | - | O₂/50 | 5 | ⊚ |
| | | | CHF₃/5 | | |
| Example 15 | 500 | - | O₂/50 | 5 | ⊚ |
| | | | CHF₃/5 | | |

As is apparent from the results shown in Table 1 and Table 2, in Examples 1 to 15 in which the mask removal step was performed by the first step including at least one of contact between the mask and the first treatment liquid containing an oxidizing agent and irradiation of the mask with plasma generated using an oxygen-containing gas, and the second step including bringing the second treatment liquid containing fluoride ions into contact with the mask after being subjected to the first step, no mask residue was observed in the line and space pattern with a line width of 30 um. In Examples 3, 7 to 9, and 11 to 15, no mask residue was also observed in the line and space pattern with a line width of 1.2 um, and the mask was extremely well removed. On the other hand, in Comparative Example 1 in which the first step was not performed, it was difficult to remove the mask. In addition, in Examples 1 to 15, the temperature of the silicon substrate during the mask removal step was less than 300°C.

## Claims

1. A method for producing a semiconductor substrate, comprising:
a mask formation step of forming a mask on a semiconductor substrate to be processed, using an energy-sensitive composition comprising an organopolysiloxane,
an ion implantation step of implanting ions into the semiconductor substrate to be processed, the semiconductor substrate being provided with the mask, and
a mask removal step of removing the mask,
wherein the mask removal step consists of:
a first step comprising at least one of:
contacting the mask with a first treatment liquid containing an oxidizing agent and
irradiating the mask with plasma generated using an oxygen-containing gas, and
a second step comprising bringing the mask after being subjected to the first step into contact with a second treatment liquid comprising fluoride ions,
wherein a temperature of the semiconductor substrate in the mask removal step is 200°C or less, and
the energy-sensitive composition comprises a photosensitizing agent and the organopolysiloxane consists of a constituent unit represented by the following formula (1): 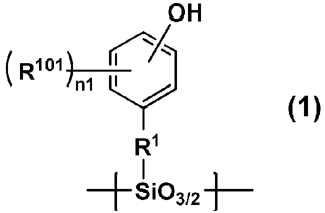
wherein R¹ represents a single bond or an alkylene group, R¹⁰¹ represents an alkyl group, and n1 represents an integer of 0 or more and 4 or less, and a constituent unit represented by the following formula (2): 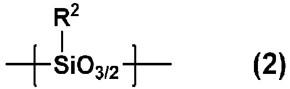
wherein R² represents an aromatic hydrocarbon group or an alkyl group.

2. The method for producing a semiconductor substrate according to claim 1,
wherein the photosensitizing agent comprises a compound having a naphthoquinonediazide group.

3. The method for producing a semiconductor substrate according to claim 1 or 2, wherein ions to be implanted by the ion implantation are ions of at least one element selected from the group consisting of aluminum, boron, gallium, indium, nitrogen, phosphorus, arsenic, and antimony.

4. The method for producing a semiconductor substrate according to any one of claims 1 to 3, wherein the mask is contacted with the first treatment liquid in the first step and the first treatment liquid comprises sulfuric acid and hydrogen peroxide.

5. The method for producing a semiconductor substrate according to any one of claims 1 to 4, wherein the second treatment liquid in the second step comprises hydrofluoric acid or a salt thereof.

## Patentansprüche

1. Verfahren zum Herstellen eines Halbleitersubstrats, umfassend:
einen Maskenbildungsschritt zum Bilden einer Maske auf einem zu verarbeitenden Halbleitersubstrat unter Verwendung einer energieempfindlichen Zusammensetzung, die ein Organopolysiloxan umfasst,
einen Ionenimplantationsschritt zum Implantieren von Ionen in das zu verarbeitende Halbleitersubstrat, wobei das Halbleitersubstrat mit der Maske versehen wird, und
einen Maskenentfernungsschritt zum Entfernen der Maske,
wobei der Maskenentfernungsschritt besteht aus:
einem ersten Schritt, der mindestens umfasst:
Inkontaktbringen der Maske mit einer ersten Behandlungsflüssigkeit, die Oxidationsmittel enthält, und
Bestrahlen der Maske mit Plasma, das unter Verwendung eines sauerstoffhaltigen Gases erzeugt wird, und
einem zweiten Schritt, umfassend Inkontaktbringen der Maske, nachdem sie dem ersten Schritt unterzogen wurde, mit einer zweiten Behandlungsflüssigkeit, die Fluoridionen umfasst,
wobei eine Temperatur des Halbleitersubstrats in dem Maskenentfernungsschritt 200 °C oder weniger ist, und
die energieempfindliche Zusammensetzung ein Photosensibilisierungsmittel umfasst und das Organopolysiloxan aus einer konstituenten Einheit besteht, die durch die folgende Formel (1) dargestellt ist: 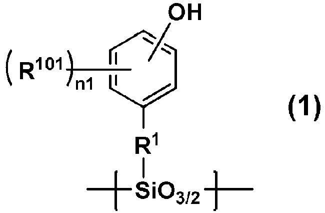
wobei R¹ eine Einfachbindung oder eine Alkylengruppe darstellt, R¹⁰¹ eine Alkylgruppe darstellt und n1 eine ganze Zahl von 0 oder mehr und 4 oder weniger darstellt, und
eine konstituente Einheit, die durch die folgende Formel (2) dargestellt ist: 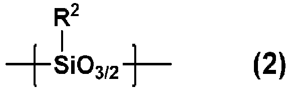
wobei R² eine aromatische Kohlenwasserstoffgruppe oder eine Alkylgruppe darstellt.

2. Verfahren zum Herstellen eines Halbleitersubstrats nach Anspruch 1,
wobei das Photosensibilisierungsmittel eine Verbindung umfasst, die eine Naphthochinondiazidgruppe aufweist.

3. Verfahren zum Herstellen eines Halbleitersubstrats nach Anspruch 1 oder 2, wobei die durch lonenimplantation zu implantierenden Ionen Ionen mindestens eines Elements sind, ausgewählt aus der Gruppe bestehend aus Aluminium, Bor, Gallium, Indium, Stickstoff, Phosphor, Arsen und Antimon.

4. Verfahren zum Herstellen eines Halbleitersubstrats nach einem beliebigen der Ansprüche 1 bis 3, wobei die Maske mit der ersten Behandlungsflüssigkeit im ersten Schritt in Kontakt gebracht wird und die erste Behandlungsflüssigkeit Schwefelsäure und Wasserstoffperoxid umfasst.

5. Verfahren zum Herstellen eines Halbleitersubstrats nach einem beliebigen der Ansprüche 1 bis 4, wobei die zweite Behandlungsflüssigkeit im zweiten Schritt Fluorwasserstoffsäure oder ein Salz davon umfasst.

## Revendications

1. Procédé de production d'un substrat semi-conducteur, comprenant :
une étape de formation de masque consistant à former un masque sur un substrat semi-conducteur à traiter, en utilisant une composition sensible à l'énergie comprenant un organopolysiloxane,
une étape d'implantation ionique consistant à implanter des ions dans le substrat semi-conducteur à traiter, le substrat semi-conducteur étant doté du masque, et
une étape de retrait de masque consistant à retirer le masque,
dans lequel l'étape de retrait de masque est constituée de :
une première étape comprenant au moins l'une parmi :
la mise en contact du masque avec un premier liquide de traitement contenant un agent oxydant et
l'irradiation du masque avec un plasma généré en utilisant un gaz contenant de l'oxygène, et
une deuxième étape comprenant la mise en contact du masque après avoir été soumis à la première étape avec un deuxième liquide de traitement comprenant des ions fluorure,
dans lequel une température du substrat semi-conducteur dans l'étape de retrait de masque est de 200 °C ou moins, et
la composition sensible à l'énergie comprend un agent photosensibilisant et l'organopolysiloxane est constitué d'un motif constitutif représenté par la formule (1) suivante : 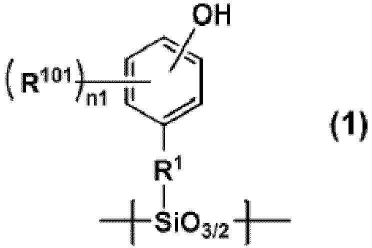
dans lequel R¹ représente une liaison simple ou un groupe alkylène, R¹⁰¹ représente un groupe alkyle, et n1 représente un nombre entier égal à 0 ou plus et 4 ou moins, et
un motif constitutif représenté par la formule (2) suivante : 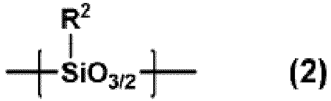
dans lequel R² représente un groupe hydrocarboné aromatique ou un groupe alkyle.

2. Procédé de production d'un substrat semi-conducteur selon la revendication 1, dans lequel l'agent photosensibilisant comprend un composé ayant un groupe naphtoquinonediazide.

3. Procédé de production d'un substrat semi-conducteur selon la revendication 1 ou 2, dans lequel les ions à implanter par l'implantation ionique sont des ions d'au moins un élément sélectionné dans le groupe constitué de l'aluminium, du bore, du gallium, de l'indium, de l'azote, du phosphore, de l'arsenic, et de l'antimoine.

4. Procédé de production d'un substrat semi-conducteur selon l'une quelconque des revendications 1 à 3, dans lequel le masque est mis en contact avec le premier liquide de traitement dans la première étape et le premier liquide de traitement comprend de l'acide sulfurique et du peroxyde d'hydrogène.

5. Procédé de production d'un substrat semi-conducteur selon l'une quelconque des revendications 1 à 4, dans lequel le deuxième liquide de traitement dans la deuxième étape comprend de l'acide fluorhydrique ou un sel de celui-ci.
